# EUROPÄISCHE PATENTSCHRIFT

(11) **EP 1 209 727 B1**
(45) Veröffentlichungstag und Bekanntmachung des Hinweises auf die Patenterteilung: **16.04.2003**
(21) Anmeldenummer: 01126579.0
(22) Anmeldetag: 15.11.2001
(51) Int. Cl.: H01L 21/306

(54) **Verfahren zur Oberflächenpolitur von Siliciumscheiben**
Process for polishing the surface of a silicon wafer
Procédé de polissage de la surface d'un substrat de silicium

(30) Priorität: 24.11.2000 DE 10058305
(43) Veröffentlichungstag der Anmeldung: 29.05.2002
(73) Patentinhaber: Wacker Siltronic AG, 84489 Burghausen (DE)
(72) Erfinder: Wenski, Guido, Dr., 84489 Burghausen (DE); Buschhardt, Thomas, 84489 Burghausen (DE); Hennhöfer, Heinrich, 84503 Altötting (DE); Lichtenegger, Bruno, 84508 Burgkirchen (DE)
(74) Vertreter: Rimböck, Karl-Heinz, Dr.

(56) Entgegenhaltungen:
- EP-A- 0 684 634
- US-A- 4 973 563

## Beschreibung

Die Erfindung betrifft ein Verfahren zur Herstellung einer Siliciumscheibe mit einer Rückseite und einer schleierfrei polierten Vorderseite, die sich für die Verwendung in der Halbleiterindustrie eignet, insbesondere zur Fabrikation von elektronischen Bauelementen im Anschluss an das Aufbringen einer epitaktischen Beschichtung.

Die Herstellung von Siliciumscheiben zur Verwendung in der Halbleiterindustrie erfolgt nach dem Stand der Technik durch Aufsägen eines Siliciumeinkristalls gefolgt von Kantenverrundung, Läppen oder Schleifen, nasschemischem Ätzen, Polieren und Reinigen. Der Politur kommen zwei wesentliche Aufgaben zu: die Erzeugung der zur Vermeidung von Fokussierungsproblemen des Steppers bei der Bauelemente-Herstellung notwendigen endgültigen Ebenheit einerseits und einer defektarmen Oberfläche andererseits, auf der - gegebenenfalls nach dem Aufbringen einer epitaktischen Beschichtung - der Ausfall von Halbleiter-Bauelementen durch elektrische Kurzschlüsse minimiert ist. Zur Erfüllung dieser Aufgaben wird die Politur von Siliciumscheiben in der Regel in zwei verschiedenen, aufeinanderfolgenden Prozessschritten ausgeführt: einer so genannten Abtragspolitur ("stock-removal polishing") unter Entfernung von etwa 10 bis 20 µm Silicium von der polierten Seite, welche die Ebenheit einstellt, und eine so genannte Oberflächenpolitur (Schleierfreipolitur; "haze-free polishing") unter Abtrag von maximal 1,5 µm Silicium, um eine defektarme Oberfläche unter bestmöglichem Erhalt der zuvor eingestellten Ebenheit zu erzeugen.

Zur Abtragspolitur werden Einseiten- und Doppelseiten-Polierverfahren eingesetzt. Bei der Einseitenpolitur wird beispielsweise nach dem Prozessschritt nasschemisches Ätzen nur eine Seite der an einer Trägervorrichtung befestigten Siliciumscheibe, in der Regel die später mit Bauelementen zu beaufschlagende Vorderseite, in Gegenwart eines Poliertuchs unter Zuführung eines Abrasivstoffe enthaltenen alkalischen Poliermittels abtragspoliert. Ein derartiges Verfahren, bei dem nacheinander zwei verschiedene Poliermittel zugeführt werden, ist in der EP 684 634 A2 beschrieben; ein in der US 5,885 334 beanspruchtes zweistufiges Verfahren arbeitet mit der Zuführung eines Abrasivstoffe enthaltenden Poliermittels gefolgt von der Zuführung eines Wasserglas enthaltenen alkalischen Poliermittels. Bei der Doppelseitenpolitur werden die durch Läuferscheiben auf ihrer Bahn gehaltenen Siliciumscheiben unter Zuführung von Poliermittel frei zwischen zwei mit Poliertuch bespannten Poliertellern bewegt und so auf Vorder- und Rückseite gleichzeitig poliert. Ein derartiges Verfahren ist beispielsweise aus der DE 199 05 737 A1 bekannt.

Niedrige Defektraten einer Seite der Siliciumscheibe, in der Regel der zur Bauelemente-Herstellung vorgesehenen Vorderseite, werden nach dem Stand der Technik durch eine Einseiten-Oberflächenpolitur erzeugt, wobei eine geeignete Kombination von Poliermittel und Poliertuch zu deutlich niedrigeren Materialabträgen als bei Abtragspolierverfahren üblich führt. Der Vorgang der Oberflächenpolitur von Siliciumscheiben ist der CMP-Politur ("chemo-mechanical planarization" = chemisch-mechanische Ein-. ebnung) von mit Vorstufen von Halbleiter-Bauelementen belegten Halbleiterscheiben, bei welchem Oberflächenfilme abgetragen oder eingeebnet werden, nicht unähnlich. Ein CMP-Prozess beispielsweise zur Politur von Wolframfilmen, bei welchem nacheinander zwei verschiedene alkalische Poliermittel zugeführt werden, ist in der US 6,040,245 beschrieben.

Für die Oberflächenpolitur von Siliciumscheiben sind modifizierte CMP-Prozesse bekannt. So wird in der DE 22 47 067 B2 vorgeschlagen, nach der Abtragspolitur eine Oberflächenpolitur mit einem Poliermittel durchzuführen, welches SiO₂ als Abrasivstoff und Polyvinylalkohol als oberflächenaktive Substanz enthält. Die EP 311 994 B1 beschreibt ebenfalls einen auf nur einem Polierteller durchführbaren Prozess, der auf der Zugabe zunächst eines alkalischen und anschließend eines sauren Poliermittels basiert, wobei die zweite Lösung polare und/oder oberflächenaktive Komponenten enthalten kann.

Auf heute am Markt erhältlichen Anlagen für die Oberflächenpolitur von Halbleiterscheiben - ein Beispiel wird in der DE 197 19 503 A1 offenbart - ist es möglich, Oberflächen-Polierprozesse unter Zuführung von zwei verschiedenen Poliermittel nach dem Stand der Technik auf zwei oder mehr als zwei verschiedenen Poliertellern auszuführen. So ist es in der betrieblichen Praxis üblich, Siliciumscheiben nach der Abtragspolitur im Rahmen der Oberflächenpolitur zunächst auf einem mit Poliertuch belegten Teller 1 mit Poliermittel A zu polieren, mit Reinstwasser zu spülen, unmittelbar anschließend auf einem mit Poliertuch belegten Teller 2 mit Poliermittel B zu polieren, erneut mit Reinstwasser zu spülen und die Scheiben einer Reinigung und Charakterisierung zuzuführen. Dabei wird die Prozessführung in der Regel so gewählt, dass auf Teller 1 vorwiegend ein Abtrag von oberflächennahen Siliciumschichten erfolgt, während auf Teller 2 eine Glättung der Oberfläche erzeugt wird, wobei der Gesamtabtrag 1,5 µm nicht übersteigt.

Nach dem Stand der Technik ist es möglich, derartig oberflächenpolierte Siliciumscheiben nach Reinigung und Trocknung mit einer einkristallin aufgewachsenen Schicht derselben Kristallorientierung beispielsweise ebenfalls aus Silicium, einer sogenannten Epitaxie- oder epitaktisch aufgewachsenen Schicht, auf welcher später Halbleiter-Bauelemente aufgebracht werden, zu beschichten. Die epitaktische Beschichtung führt dabei zu gewissen dem Fachmann bekannten Vorteilen, beispielsweise einer Eliminierung des so genannten Latch-up-Problems in bipolaren CMOS-Schaltkreisen sowie der Abwesenheit eines nenneswerten Sauerstoffgehaltes, womit das Risiko von potentiell Schaltkreis-zerstörenden Sauerstoffpräzipitaten in Bauelemente-relevanten Bereichen ausgeschlossen ist. Jedoch führen die Oberflächen-Polierprozesse nach dem Stand der Technik zu Siliciumscheiben, die im Anschluss an eine epitaktische Beschichtung eine gewisse Anzahl von nicht abreinigbaren Oberflächendefekten aufweisen, etwa Stapelfehler und sonstiger Streulichtdefekte, die durch eine Lasermessung beispielsweise im Größenbereich ab 0,12 µm erkannt werden und durch elektrische Kurzschlüsse zu Ausfällen im Bauelemente-Herstellprozess führen können.

Es war daher die Aufgabe gestellt, ein Verfahren zur Oberflächenpolitur einer Siliciumscheibe bereitzustellen, das zu einer verringerten Anzahl von Oberflächendefekten nach Aufbringung einer epitaktischen Beschichtung auf dieser Siliciumscheibe und damit zu Kosteneinsparungen im Bauelemente-Herstellprozess führt.

Gegenstand der Erfindung ist ein Verfahren zur Oberflächenpolitur einer Siliciumscheibe umfassend die aufeinander folgende Politur der Siliciumscheibe auf mindestens zwei verschiedenen, mit Poliertuch belegten Poliertellern unter kontinuierlicher Zuführung von alkalischem Poliermittel mit SiO₂-Anteilen, wobei ein beim Polieren erzielter Siliciumabtrag auf einem ersten Polierteller signifikant höher ist als auf einem zweiten Polierteller und einen Gesamtabtrag von 1,5 µm nicht übersteigt, das dadurch gekennzeichnet ist, dass auf dem ersten Polierteller ein erstes Poliermittel (1a), danach ein Gemisch aus einem zweiten Poliermittel (1b) und mindestens einem Alkohol und schließlich Reinstwasser (1c) und auf dem zweiten Teller ein Gemisch aus einem dritten Poliermittel (2a) und mindestens einem Alkohol und anschließend Reinstwasser (2b) zugegeben werden.

Wesentliches Merkmal der Erfindung ist es, dass der verbesserte Oberflächen-Polierprozess, bei dem auf beiden Poliertellern unter anderem ein Gemisch aus Poliermittel und Alkohol zugegeben wird, zu einer im Vergleich mit Prozessen nach dem Stand der Technik deutlichen Verringerung von Streulichtdefekten, insbesondere von Stapelfehlern, auf einer auf dieser Oberfläche aufgebrachten epitaktischen Beschichtung führt, was höhere Ausbeuten und damit niedrigere Kosten bei der Herstellung von Halbleiter-Bauelementen mit sich bringt. Dies war überraschend und nicht vorhersehbar.

Ausgangsprodukt des Verfahrens ist eine mindestens auf einer Vorderseite abtragspolierte Siliciumscheibe. Endprodukt des Verfahrens ist eine auf einer Vorderseite oberflächenpolierte Siliciumscheibe, die nach epitaktischer Beschichtung als Ausgangsmaterial für Halbleiterbauelemente-Prozesse den nach dem Stand der Technik hergestellten Siliciumscheiben auf Grund einer signifikant niedrigeren Anzahl von Streulichtdefekten überlegen ist.

Das erfindungsgemäße Verfahren kann prinzipiell zur Herstellung von Siliciumscheiben verschiedenster in der Halbleiterbranche üblicher Durchmesser eingesetzt werden; es eignet sich besonders zur Herstellung einkristalliner Siliciumscheiben mit Durchmessern von 150 mm bis 450 mm und Dicken von 400 µm bis 1000 µm. Erfindungsgemäß erzeugte Siliciumscheiben können entweder direkt als Ausgangsmaterial für die Herstellung von Halbleiterbauelementen eingesetzt werden oder nach Aufbringen von Schichten wie Rückseitenversiegelungen oder einer epitaktischen Beschichtung der Scheibenvorderseite beispielsweise mit Silicium und/oder nach Konditionierung durch eine Wärmebehandlung beispielsweise unter Wasserstoff- oder Argonatmosphäre ihrem Bestimmungszweck zugeführt werden. Neben der Herstellung von Scheiben aus einem homogenen Material kann die Erfindung natürlich auch zur Herstellung von mehrschichtig aufgebauten Produkten wie SOI-Scheiben ("silicon-on-insulator") eingesetzt werden.

Prinzipiell ist es möglich, eine Vielzahl beispielsweise durch ein Innenloch- oder Drahtsägeverfahren gesägter Siliciumscheiben, deren oberflächennahen Bereiche je nach Durchmesser und Art des Sägeprozesses ein zerstörtes Kristallgefüge ("Damage") bis in eine Tiefe im Bereich von 10 bis 40 µm aufweisen, nach Ausführung einer Abtragspolitur direkt dem erfindungsgemäßen Oberflächen-Polierprozess zu unterziehen. Es ist jedoch sinnvoll und daher bevorzugt, die scharf begrenzten und daher mechanisch sehr empfindlichen Scheibenkanten mit Hilfe geeignet profilierter Schleifscheiben zu verrunden. Geeignete Schleifscheiben bestehen aus Metall- oder Kunstharz-gebundenen Diamanten.

Zwecks Geometrieverbesserung und teilweisem Abtrag von Damage ist es möglich, die Siliciumscheiben einem mechanischen Abtragsschritt wie Läppen oder Schleifen zu unterziehen, um den Materialabtrag im Abtragspolierschritt zu reduzieren. Beide Verfahren sind gleichermaßen bevorzugt. Besonders bevorzugt bei Durchführung eines Schleifverfahrens ist, beide Seiten sequentiell oder beide Seiten gleichzeitig zu schleifen. Zwecks Damage-Entfernung von Scheibenoberfläche und -kante und zur Eliminierung von insbesondere metallischen Verunreinigungen wird an dieser Stelle ein Ätzschritt bevorzugt, der besonders bevorzugt als nasschemische Behandlung der Siliciumscheibe in einer alkalischen oder sauren Ätzmischung unter Abtrag von 1 bis 50 µm Silicium ausgeführt werden kann.

Es folgt ein Abtragspolierschritt, der entweder als Einseiten-Abtragspolitur der Vorderseite der Siliciumscheibe oder als Doppelseitenverfahren unter gleichzeitiger Politur der Vorderseite und der Rückseite der Siliciumscheibe ausgeführt werden kann. Die Wahl des Abtragspolierverfahrens richtet sich nach dem Durchmesser und den Anforderungen an die fertig prozessierte Siliciumscheibe, beispielsweise ob eine geätzte oder polierte Rückseite gewünscht wird oder welche geometrischen und nanotopografischen Anforderungen zu erfüllen sind. In der Regel werden Siliciumscheiben mit Durchmessern unter 200 mm einseitig abtragspoliert, während bei Durchmessern über 200 mm der Doppelseitenpolitur der Vorzug gegeben wird; im Falle von 200-mm-Scheiben finden beide Verfahren Anwendung. Bevorzugt ist eine Ausführung unter Verwendung eines aufgeklebten handelsüblichen Polyurethan-Poliertuches einer Härte von 60 bis 90 (Shore A), das gegebenenfalls verstärkende Polyesterfasern enthält, unter kontinuierlicher Zuführung eines Poliermittels aus 1 bis 10 Gew.-% SiO₂ in Reinstwasser, das durch Alkalizugaben, beispielsweise Na₂CO₃, K₂CO₃, NaOH, KOH, NH₄OH und Tetramethylammoniumhydroxid, auf einen pH-Wert im Bereich von 9 bis 12 eingestellt wird.

Ein bevorzugtes Ausgangsmaterial für das erfindungsgemäße Verfahren ist eine Siliciumscheibe mit einem Durchmesser von 150 mm oder 200 mm, hergestellt durch Innenlochsägen eines Silicium-Einkristalls gefolgt von Kantenverrunden, Läppen unter Abtrag von insgesamt 20 µm bis 150 µm Silicium, nasschemischem Ätzen in einer alkalischen Ätzmischung unter Abtrag von 10 µm bis 50 µm Silicium pro Scheibenseite und Einseiten-Abtragspolitur unter Abtrag von 5 µm bis 25 µm Silicium. Ein weiteres bevorzugtes Ausgangsmaterial für das erfindungsgemäße Verfahren ist eine Siliciumscheibe mit einem Durchmesser von gleich oder größer 200 mm, hergestellt durch Drahtsägen eines Silicium-Einkristalls gefolgt von Kantenverrunden, sequentiellem Oberflächenschleifen beider Scheibenseiten unter Abtrag von 10 µm bis 100 µm Silicium pro Seite, nasschemischem Ätzen in einer sauren Ätzmischung unter Abtrag von 1 µm bis 40 µm Silicium pro Scheibenseite und Doppelseitenpolitur unter Abtrag von insgesamt 5 µm bis 50 µm Silicium.

Zur Durchführung des erfindungsgemäßen Oberflächen-Polierschrittes zur Bereitstellung einer schleierfrei polierten Vorderseite kann eine handelsübliche Oberflächenpoliermaschine mit mindestens zwei Poliertellern eingesetzt werden, wobei in einem Poliervorgang entweder eine einzelne Siliciumscheibe oder mehrere Siliciumscheiben gleichzeitig poliert werden; beide Vorgehensweisen sind gleichermaßen bevorzugt. Zum Halten der Siliciumscheiben während der Oberflächenpolitur sind im Rahmen der Erfindung wachsfreie Prozesse bevorzugt, bei denen eine oder mehrere Siliciumsscheiben durch Anlegen von Vakuum oder/oder durch Wasser-unterstützte Adhäsion von einer mit einem elastischen, porösen Film bedeckten starren Trägerplatte gehalten werden. Derartige Trägervorrichtungen sind beispielsweise in der US 5,605,488 oder der US 5,893,755 beschrieben. Der elastische, zum Kontakt mit der Scheibenrückseite eingesetzte Film ist dabei bevorzugt aus Polymerschaum, besonders bevorzugt aus Polyurethan, gefertigt. Zur Verbesserung der Haftung der zu polierenden Scheibe ist eine Texturierung mit Kanälen beispielsweise gemäß US 5,788,560 möglich. Ebenfalls im Rahmen der Erfindung besonders bevorzugt ist der Einsatz einer Trägervorrichtung, die anstelle der starren Trägerplatte über eine elastische Membran verfügt, deren Anwendung beispielsweise in der in US 5,449,316 und der US 5,851,140 beansprucht ist und die gegebenenfalls mit einer Schutzschicht beaufschlagt wird, beispielsweise einem elastischen Film aus Polyurethanschaum.

Bei der Oberflächenpolitur der Vorderseite der Siliciumscheibe wird bevorzugt mit einem aufgeklebten weichen Poliertuch unter kontinuierlicher Zuführung eines wässrigen alkalischen Poliermittels auf SiO₂-Basis poliert. Dabei wird auf dem ersten Teller ein Poliermittel (1a), dann ein Gemisch aus einem Poliermittel (1b) und mindestens einem Alkohol und schließlich Reinstwasser (1c) und auf dem zweiten Polierteller ein Gemisch aus einem Poliermittel (2a) und mindestens einem Alkohol und anschließend Reinstwasser (2b) zugegeben. Wird eine Polieranlage benutzt, die über beispielsweise drei Teller verfügt, so wird der überzählige Polierteller entweder nicht benutzt, oder es erfolgt eine Anpassung der Rezeptur des dritten Polierteller an den erfindungsgemäßen Zweitellerprozess, indem beispielsweise die Abfolge des erfindungsgemäßen zweiten Tellers auf dem verfügbaren zweiten und dritten Teller gefahren wird.

Das Poliermittel (1a) besteht bevorzugt im Wesentlichen aus einer kolloidalen Mischung von 1 bis 10 Gew.-% SiO₂ in Wasser. Besonders bevorzugt ist die Verwendung eines Produktes auf der Basis von gefällter Kieselsäure als SiO₂-Anteil. Bevorzugt wird zur Erhöhung der Silicium-Abtragsrate durch Zusatz von Alkali, besonders bevorzugt aus der Gruppe der Verbindungen Na₂CO₃, K₂CO₃, NaOH, KOH, NH₄OH und Tetramethylammoniumhydroxid in Anteilen von 0,01 bis 10 Gew.-%, ein pH-Wert zwischen 10,5 und 12,0 eingestellt.

Die Poliermittel (1b) und (2a) bestehen bevorzugt im Wesentlichen aus einer kolloidalen Mischung von 0,1 bis 5 Gew.-% SiO₂ in Wasser unter Zusatz mindestens eines Alkohols und besitzen bevorzugt einen pH-Wert zwischen 9,0 und 10,5. Es ist möglich, mit (1a) und (2b) das gleiche Poliermittel/Alkohol-Gemisch einzusetzen, obwohl dies im Rahmen der Erfindung nicht zwingend erforderlich ist.

Als Poliermittel (1b) und (2a) eignen sich besonders wässrige Suspensionen, die SiO₂-Teilchen in einer Korngröße zwischen 5 und 50 nm enthalten, wobei die Verwendung von durch Pyrolyse von Si(OH)₄ hergestellter SiO₂-Teilchen ("pyrogene Kieselsäure") besonders bevorzugt ist. In gewissen Fällen kann es sich jedoch als sinnvoll erweisen, auch in diesen Schritten gefällte Kieselsäure einzusetzen. Als Alkoholzusatz eignen sich im Rahmen der Erfindung einwertige, das heisst über eine OH-Gruppe verfügende, oder mehrwertige, das heisst über zwei oder mehr OH-Gruppen verfügende organische Alkohole in Reinform oder als Gemisch. Der Alkohol führt dabei durch Kondensationsreaktion mit der hydrophoben Siliciumoberfläche, die über Si-H-Endgruppen verfügt, zu einer Reduktion der Abtragsrate und damit zu einer Glättung der Oberfläche, und zwar um so effektiver, je mehr OH-Gruppen der Alkohol besitzt. Besonders bevorzugt ist daher der Zusatz eines oder verschiedener mehrwertiger Alkohole in einem Anteil von 0,01 bis 10 Vol-%.

Der Abtrag an Silicium sollte im erfindungsgemäßen Verfahren bevorzugt 1,5 µm und besonders bevorzugt 1 µm nicht übersteigen, um einerseits die Erfüllung etwaiger Ebenheitsanforderungen an die Scheibe nicht zu gefährden und andererseits die Prozesskosten möglichst niedrig zu halten. Dabei führt die erfindungsgemäße Prozessführung - insbesondere die Ausführung des Polierschrittes mit dem Poliermittel (la)- dazu, dass auf dem ersten Polierteller deutlich mehr Silicium, bevorzugt mindestens doppelt so viel, abgetragen wird als auf dem zweiten Polierteller 2. Der Effekt lässt sich vorteilhafter Weise noch dadurch unterstützen, dass auf dem ersten Polierteller ein etwas härteres Poliertuch als auf dem zweiten Polierteller verwendet wird. Damit dient die Politur auf dem ersten Polierteller bevorzugt der Entfernung von Defekten und deren Glättung und die Politur auf dem zweiten Polierteller bevorzugt der Entfernung des Schleiers und damit der Anpassung der Oberflächenrauigkeit an die Anforderungen der Folgeprozesse.

Als Alkoholzusatz kommen nahezu alle Alkohole in Betracht, die sich in der gewünschten Konzentration mit dem Poliermittel mischen lassen und chemisch stabil sind. Ein Beispiel ist n-Butanol. Der bevorzugt eingesetzte mehrwertige Alkohol ist bevorzugt in der Liste der Verbindungen und Verbindungsklassen Glycerin (Propantriol-1,2,3), monomere Glykole, oligomere Glykole, Polyglykole und Polyalkohole enthalten. Beispiele für geeignete monomere Glykole sind Ethylenglykol (Ethandiol-1,2), Propylenglykole (Propandiol-1,2 und -1,3) und Butylenglykole (Butandiol-1,3 und -1,4). Beispiele für geeignete oligomere Glykole sind Diethylenglykol, Triethylenglykol, Tetraethylenglykol und Dipropylenglykol. Beispiele für Polyglykole sind Polyethylenglykol, Polypropylenglykol und gemischte Polyether. Beispiele für Polyalkohole sind Poylvinylalkohole und Polyetherpolyole. Die genannten Verbindungen sind kommerziell erhältlich, bei Polymeren oft in verschiedenen Kettenlängen.

Der Alkoholzusatz konserviert die Oberfläche der Siliciumscheibe nach den Polierschritten mit den Poliermitteln (1b) und (2a) und verhindert eine Fleckenbildung im Anschluss an die Behandlung mit Reinstwasser. Der Alkohol begünstigt außerdem ein Beibehalten der Rotationsverhältnisse der Polierteller bei der Zugabe von Reinstwasser (1c) und (2b). Eine sich anschließende Reinigung und Trocknung der Siliciumscheiben nach dem Stand der Technik, die in Form von Batch- oder Einzelscheibenverfahren ausgeführt werden kann, entfernt eventuell vorhandene Alkoholreste vollständig.

Falls notwendig, kann an einer beliebigen Stelle der Prozesskette eine Wärmebehandlung eingefügt werden, beispielsweise um thermische Donatoren zu vernichten, um eine Störung von oberflächennahen Kristallschichten auszuheilen oder um in letztgenannten Schichten eine gezielte Dotierstoffverarmung herbeizuführen. Weiterhin können eine Laserbeschriftung zur Scheibenidentifizierung und/oder ein Kantenpolierschritt an geeigneter Stelle eingefügt werden. Eine Reihe weiterer, für bestimmte Produkte erforderliche Prozessschritte, beispielsweise die Aufbringung von Rückseitenbeschichtungen, lässt sich ebenfalls nach dem Fachmann bekannten Verfahren an den geeigneten Stellen in die Prozesskette einbauen.

Die Siliciumscheibe kann anschließend einer Weiterverarbeitung durch Aufbringung einer epitaktischen Beschichtung beispielsweise aus Silicium oder direkt der Bauelementeherstellung zugeführt werden. Insbesondere im Falle der epitaxierten Scheibe lassen sich durch laserunterstützte instrumentelle Inspektion sehr niedrige Defektzahlen feststellen, womit das erfindungsgemäße Verfahren den Verfahren nach dem Stand der Technik überlegen ist.

Zum nachfolgend beschriebenen Vergleichsbeispiel und zum Beispiel gehören Figuren, welche die Erfindung verdeutlichen, jedoch keine Einschränkung bedeuten.

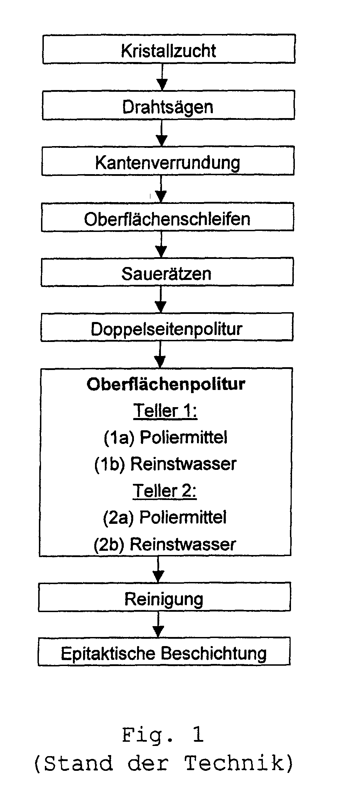

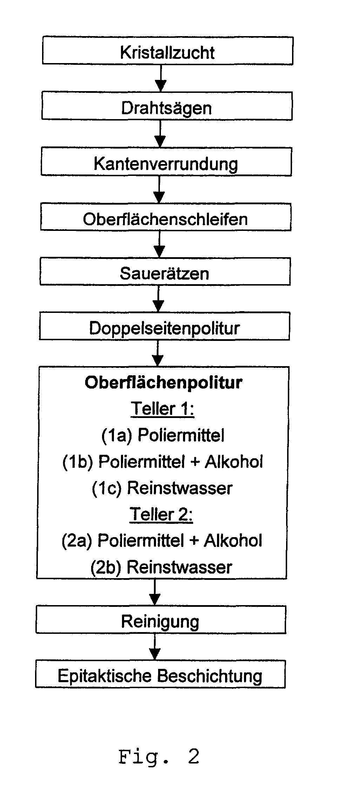

Fig. 1 zeigt die Prozessabfolge zur Herstellung einer Siliciumscheibe mit abtragspolierter Rückseite und oberflächenpolierter und epitaktisch beschichteter Vorderseite gemäß Vergleichsbeispiel. Fig. 2 zeigt die Prozessabfolge zur Herstellung einer Siliciumscheibe mit abtragspolierter Rückseite und oberflächenpolierter und epitaktisch beschichteter Vorderseite gemäß Beispiel.

Vergleichsbeispiel und Beispiel betreffen die Herstellung von Siliciumscheiben mit einem Durchmesser von 300 mm und einer Bor-Dotierung, die zu einem Widerstand im Bereich von 5 bis 10 mΩ·cm führt, und die eine epitaktische Siliciumschicht auf der Vorderseite mit einer Bor-Dotierung, die zu einem Widerstand im Bereich von 1 bis 10 Ω·cm führt, besitzen. Dazu wurden Einkristalle gezogen, abgelängt und rundgeschliffen und auf einer Drahtsäge in Scheiben zerteilt. Nach Verrundung der Kante wurden auf einer Rotationsschleifmaschine nacheinander von der Scheibenvorder- und -rückseite je 40 µm Silicium abgetragen. Daran schloss sich ein saurer Ätzschritt in einer Mischung aus konzentrierter Salpetersäure und konzentrierter Flusssäure an, wobei pro Scheibenseite gleichzeitig je 10 µm Silicium abgetragen wurden. Im Doppelseiten-Abtragspolierschritt wurden zwischen einem oberen und einem unteren mit einem Poliertuch des Typs SUBA500 von Fa. Rodel beklebten Polierteller mit Hilfe von fünf Läuferscheiben aus rostfreiem Chromstahl, die über jeweils drei mit PVDF ausgekleidete Aussparungen verfügten, unter Zuführung eines Poliermittels des Typs Levasil 200 der Bayer AG mit einem SiO₂-Feststoffgehalt von 3 Gew.-% und einem auf einen auf 11 eingestellten pH-Wert gleichzeitig 15 der 300-mm-Siliciumscheiben auf einer handelsüblichen Doppelseiten-Poliermaschine unter Abtrag von insgesamt 30 µm Silicium poliert. Nach Reinigung von anhaftendem Poliermittel und Trocknung wurden die Scheiben zur Oberflächenpolitur der Vorderseite überführt. Hierfür stand eine handelsübliche Oberflächen-Polieranlage mit zwei getrennten drehbaren Poliertellern und rotierenden Trägervorrichtungen für Siliciumscheiben des Durchmessers 300 mm zur Verfügung, die über Kanäle zum Ansaugen einer Halbleiterscheibe mittels Anlegen von Vakuum beziehungsweise Abstoßen der Siliciumscheibe mittels Überdruck verfügte und im Wesentlichen aus einer mit einem elastischen Polyurethanfilm beklebten starren Trägerplatte und einem ebenfalls aufgeklebten seitlichen Begrenzungsring aufgebaut war.

### Vergleichsbeispiel

Auf Teller 1 wurde mit einem Polytex-Poliertuch von Fa. Rodel unter Zugabe des Poliermittels Levasil 300 (3 Gew.-% SiO₂ in Reinstwasser; pH-Wert durch K₂CO₃-Zugabe auf 10,5 eingestellt) für eine Zeitdauer von 150 sec poliert. Anschließend wurde unter fortgesetzter Drehung von Polierteller und Spindel für eine Zeitdauer von 30 sec Reinstwasser zugeführt. Teller 2 war mit einem Poliertuch des Typs Napcon 4500 N2 von Fa. Nagase beklebt. Zur Ausführung des zweiten, glättenden Polierschrittes wurde das Poliermittel Glanzox 3900 (1 Gew.-% SiO₂ in Reinstwasser; pH-Wert 9,8) für eine Zeitdauer von 120 sec zugeführt, gefolgt von einer Zuführung von Reinstwasser für eine Zeitdauer von 30 sec unter fortgesetzter Drehung von Polierteller und Spindel. Der Gesamt-Siliciumabtrag von der Vorderseite der Siliciumscheibe betrug im Mittel 0,6 µm, wovon ca. 0,5 µm auf Polierteller 1 abgetragen wurden.

### Beispiel

Es wurde vorgegangen wie im Vergleichsbeispiel, wobei für die Oberflächenpolitur bei gleicher Wahl der Poliertücher folgende Vorgehensweise gewählt wurde: Auf Teller 1 wurde zunächst wiederum mit Levasil 300 (3 Gew.-% SiO₂; pH 10,5) poliert, diesmal für eine Zeitdauer von 120 sec. Es folgte für eine Zeitdauer von 40 sec die Zugabe eines Poliermittels, das aus einer wässrigen Suspension aus pyrogener Kieselsäure (SiO₂-Teilchengröße 30-40 nm; Feststoffgehalt 1,5 Gew.-%; NH₄OH-stabilisiert) bestand, der 0,2 Vol-% Triethylenglykol beigemischt wurden und die einen pH-Wert von 9,7 besaß. Anschließend wurde für 20 sec Reinstwasser zugeführt. Auf Teller 2 wurde bei ansonsten gleicher Fahrweise wie im Vergleichsbeispiel die gleiche Suspension aus pyrogener Kieselsäure mit Triethylenglykol-Beimischung wie auf Teller 1 verwendet. Der Gesamt-Siliciumabtrag von der Vorderseite der Siliciumscheibe betrug diesmal im Mittel 0,5 µm, wovon ca. 0,4 µm auf Teller 1 abgetragen wurden.

### Epitaktische Beschichtung und Charakterisierung

Nach Reinigung in einer Badanlage und Trocknung wurden die Siliciumscheiben aus Vergleichsbeispiel und Beispiel in einem Epitaxiereaktor des Typs Centura HT308 der Fa. Applied Materials auf der oberflächenpolierten Vorderseite bei einer Reaktorkammertemperatur von 1100 °C und bei einer Abscheiderate von 3 µm/min mit 2,0 µm Silicium epitaktisch beschichtet, wobei als Siliciumkomponente SiHCl₃ zum Einsatz kam und der Widerstand durch Dotierung mit Diboran, B₂H₆, eingestellt wurde.

Die Vorderseite von jeweils 150 der epitaxierten Siliciumscheiben aus Vergleichsbeispiel und Beispiel wurde auf einem nach dem Laserprinzip arbeitenden Oberflächeninspektionsgerät des Typs SP1 der Fa. KLA-Tencor hinsichtlich der Anzahl der Defekte auf der epitaxierten Vorderseite charakterisiert. Für die Gesamtzahl der Streulichtdefekte gleich oder größer 0,12 µm ergab sich im DCN-Kanal ("dark field composite") ein Mittelwert von 101 ± 19 (Vergleichsbeispiel) beziehungsweise 12 ± 4 (Beispiel). Eine lichtmikroskopische Untersuchung der Defekte zeigte, dass es sich im Falle des Vergleichsbeispiels in der Hauptsache um Stapelfehler handelte, während auf den Scheiben des Beispiels nahezu keine Stapelfehler beobachtet wurden.

## Patentansprüche

1. Verfahren zur Oberflächenpolitur einer Siliciumscheibe umfassend die aufeinander folgende Politur der Siliciumscheibe auf mindestens zwei verschiedenen, mit Poliertuch belegten Poliertellern unter kontinuierlicher Zuführung von alkalischem Poliermittelmit SiO₂-Anteilen, wobei ein beim Polieren erzielter Siliciumabtrag auf einem ersten Polierteller signifikant höher ist als auf einem zweiten ist als auf einem Polierteller und einen Gesamtabtrag von 1,5 µm nicht übersteigt, **dadurch gekennzeichnet, dass** auf dem ersten Polierteller ein erstes Poliermittel (1a), dann ein Gemisch aus einem zweiten Poliermittel (1b) und mindestens einem Alkohol und schließlich Reinstwasser (1c) und auf dem zweiten Polierteller ein Gemisch aus einem dritten Poliermittel (2a) und mindestens einem Alkohol und anschließend Reinstwasser (2b) zugegeben werden.

2. Verfahren nach Anspruch 1, **dadurch gekennzeichnet, dass** die Oberflächenpolitur auf einer abtragspolierten Seite der Siliciumscheibe ausgeführt wird, wobei bei der Abtragspolitur auf dieser Seite zwischen 5 µm und 25 µm Silicium entfernt wurden.

3. Verfahren nach einem der Ansprüche 1 bis 2, **dadurch gekennzeichnet, dass** die bei der Oberflächenpolitur eingesetzten Poliermittel einen SiO₂-Gehalt zwischen 0,1 und 10 Gew.-% und einen pH-Wert zwischen 9 und 12 besitzen.

4. Verfahren nach einem der Ansprüche 1 bis 3, **dadurch gekennzeichnet, dass** das erste Poliermittel (1a) einen höheren pH-Wert besitzt als das zweite Poliermittel (1b).

5. Verfahren nach einem der Ansprüche 1 bis 4, **dadurch gekennzeichnet, dass** die zweiten und dritten Poliermittel (1b) und (2a) identisch und zum ersten Poliermittel (1a) verschieden sind.

6. Verfahren nach einem der Ansprüche 1 bis 5, **dadurch gekennzeichnet, dass** das erste Poliermittel (1a) im Wesentlichen aus einer kolloidalen Mischung von 1 bis 10 Gew.-% SiO₂ in Wasser unter Zusatz von Alkali besteht und einen pH-Wert von 10,5 bis 12,0 besitzt und die zweiten und dritten Poliermittel (1b) und (2a) im Wesentlichen aus einer kolloidalen Mischung von 0,1 bis 5 Gew.-% SiO₂ in Wasser unter Zusatz mindestens eines Alkohols bestehen und einen pH-Wert von 9,0 bis 10,5 besitzen.

7. Verfahren nach einem der Ansprüche 1 bis 6, **dadurch gekennzeichnet, dass** der Alkalizusatz zum ersten Poliermittel (1a) aus einer oder mehreren Verbindungen aus der Gruppe der Verbindungen Na₂CO₃, K₂CO₃, NaOH, KOH, NH₄OH und Tetramethylammoniumhydroxid in Anteilen von 0,01 bis 10 Gew.-% besteht.

8. Verfahren nach einem der Ansprüche 1 bis 7, **dadurch gekennzeichnet, dass** das erste Poliermittel (1a) als SiO₂-Komponente gefällte Kieselsäure mit einem Korndurchmesser zwischen 5 und 50 nm enthält und die zweiten und dritten Poliermittel (1b) und (2a) als SiO₂-Komponente pyrogene Kieselsäure mit einem Korndurchmesser zwischen 5 und 50 nm enthalten.

9. Verfahren nach einem der Ansprüche 1 bis 8, **dadurch gekennzeichnet, dass** die zweiten und dritten Poliermittel (1b) und (2a) mindestens einen mehrwertige Alkohol aus der Liste der Verbindungen und Verbindungsklassen Glycerin, monomere Glykole, oligomere Glykole, Polyglykole und Polyalkohole enthalten, der in Anteilen von 0,01 bis 10 Vol-% eingesetzt wird.

10. Verfahren nach einem der Ansprüche 1 bis 9, **dadurch gekennzeichnet, dass** das auf dem zweiten Polierteller eingesetzte Poliertuch weicher ist als das auf dem ersten Polierteller eingesetzte Poliertuch.

11. Verfahren nach einem der Ansprüche 1 bis 10, **dadurch gekennzeichnet, dass** nach der Oberflächenpolitur eine Reinigung und Trocknung der Siliciumscheibe gefolgt von der Aufbringung einer epitaktischen Beschichtung auf die Siliciumscheibe ausgeführt wird.

## Claims

1. Process for the surface polishing of a silicon wafer, comprising the successive polishing of the silicon wafer on at least two different polishing plates covered with polishing cloth, with a continuous supply of alkaline polishing abrasive with SiO₂ constituents, an amount of silicon removed during the polishing on a first polishing plate being significantly higher than on a second polishing plate, with the overall amount of silicon removed not exceeding 1.5 µm, **characterized in that** a first polishing abrasive (1a), then a mixture of a second polishing abrasive (1b) and at least one alcohol, and finally ultrapure water (1c) are added to the first polishing plate, and a mixture of a third polishing abrasive (2a) and at least one alcohol and then ultrapure water (2b) are added to the second polishing plate.

2. Process according to Claim 1, **characterized in that** the surface polishing is carried out on a surface of the silicon wafer which has undergone stock-removal polishing, between 5 µm and 25 µm of silicon being removed during the stock-removal polishing on this surface.

3. Process according to either of Claims 1 and 2, **characterized in that** the polishing abrasives used for the surface polishing have an SiO₂ content of between 0.1 and 10% by weight and a pH of between 9 and 12.

4. Process according to one of Claims 1 to 3, **characterized in that** the first polishing abrasive (1a) has a higher pH than the second polishing abrasive (1b).

5. Process according to one of Claims 1 to 4, **characterized in that** the second and third polishing abrasives (1b) and (2a) are identical and are different from the first polishing abrasive (1a).

6. Process according to one of Claims 1 to 5, **characterized in that** the first polishing abrasive (1a) substantially comprises a colloidal mixture of from 1 to 10% by weight of SiO₂ in water with the addition of alkali and has a pH of from 10.5 to 12.0, and the second and third polishing abrasives (1b) and (2a) substantially comprise a colloidal mixture of from 0.1 to 5% by weight of SiO₂ in water with the addition of at least one alcohol and have a pH of from 9.0 to 10.5.

7. Process according to one of Claims 1 to 6, **characterized in that** the alkali added to the first polishing abrasive (1a) comprises one or more compounds selected from the group of compounds consisting of Na₂CO₃, K₂CO₃, NaOH, KOH, NH₄OH and tetramethylammonium hydroxide in proportions of from 0.01 to 10% by weight.

8. Process according to one of Claims 1 to 7, **characterized in that** the first polishing abrasive (1a) contains precipitated silica with a grain diameter of between 5 and 50 nm as the SiO₂ component, and the second and third polishing abrasives (1b) and (2a) contain pyrogenic silica with a grain diameter of between 5 and 50 nm as the SiO₂ component.

9. Process according to one of Claims 1 to 8, **characterized in that** the second and third polishing abrasives (1b) and (2a) contain at least one polyhydric alcohol selected from the list of compounds and compound classes consisting of glycerol, monomeric glycols, oligomeric glycols, polyglycols and polyalcohols, which is used in proportions of from 0.01 to 10% by volume.

10. Process according to one of Claims 1 to 9, **characterized in that** the polishing cloth used on the second polishing plate is softer than the polishing cloth used on the first polishing plate.

11. Process according to one of Claims 1 to 10, **characterized in that** after the surface polishing, cleaning and drying of the silicon wafer followed by the application of an epitaxial coating to the silicon wafer is carried out.

## Revendications

1. Procédé pour le polissage de surface d'un disque de silicium, comprenant les polissages successifs du disque de silicium sur au moins deux plateaux de polissage différents occupés par des chiffons de polissage et l'apport en continu d'un agent de polissage alcalin présentant une teneur en SiO₂, l'enlèvement du silicium obtenu par le polissage sur un premier plateau de polissage étant significativement plus élevé que celui sur un deuxième plateau de polissage et un enlèvement total de 1,5 µm n'étant pas dépassé, **caractérisé en ce que** sur le premier plateau de polissage sont apportés un premier agent de polissage (1a), ensuite un mélange d'un deuxième agent de polissage (1b) et d'au moins un alcool et enfin de l'eau très pure (1c) et **en ce que** sur le deuxième plateau de polissage sont apportés un mélange d'un troisième agent de polissage (2a) et d'au moins un alcool et ensuite de l'eau très pure (2b).

2. Procédé selon la revendication 1, **caractérisé en ce que** le polissage de surface est réalisé sur un côté du disque de silicium qui est poli par enlèvement, de 5 µm à 25 µm de silicium étant enlevés de ce côté par le polissage par enlèvement.

3. Procédé selon l'une des revendications 1 à 2, **caractérisé en ce que** les agents de polissage utilisés lors du polissage de surface présentent une teneur en SiO₂ comprise entre 0,1 et 10 % en poids et un pH d'une valeur comprise entre 9 et 12.

4. Procédé selon l'une des revendications 1 à 3, **caractérisé en ce que** le premier agent de polissage (1a) présente un pH d'une valeur plus élevée que le deuxième agent de polissage (1b).

5. Procédé selon l'une des revendications 1 à 4, **caractérisé en ce que** le deuxième et le troisième agent de polissage (1b) et (2a) sont identiques et sont différents du premier agent de polissage (1a).

6. Procédé selon l'une des revendications 1 à 5, **caractérisé en ce que** le premier agent de polissage (1a) est essentiellement constitué d'un mélange colloïdal de 1 à 10 % en poids de SiO₂ dans l'eau avec addition d'un alcali et un pH d'une valeur de 10,5 à 12,0, le deuxième et le troisième agent de polissage (1b) et (2a) étant essentiellement constitués d'un mélange colloïdal de 0,1 à 5 % en poids de SiO₂ dans l'eau avec addition d'au moins un alcool et un pH d'une valeur de 9,0 à 10,5.

7. Procédé selon l'une des revendications 1 à 6, **caractérisé en ce que** l'addition d'alcali au premier agent de polissage (1a) est constituée d'un ou de plusieurs composés du groupe des composés Na₂CO₃, K₂CO₃, NaOH, KOH, NH₄OH et hydroxyde de tétraméthylammonium en proportions de 0,01 à 10 % en poids.

8. Procédé selon l'une des revendications 1 à 7, **caractérisé en ce que** le premier agent de polissage (1a) contient comme composant de SiO₂ de l'acide silicique précipité qui présente des grains d'un diamètre compris entre 5 et 50 nm, le deuxième et le troisième agent de polissage (1b) et (2a) contenant comme composant de SiO₂ de l'acide silicique pyrogène qui présente des grains d'un diamètre compris entre 5 et 50 nm.

9. Procédé selon l'une des revendications 1 à 8, **caractérisé en ce que** le deuxième et le troisième agent de polissage (1b) et (2a) contiennent au moins un alcool polyhydroxylique repris dans la liste des composés et des classes de composés glycérine, glycols monomères, glycols oligomères, polyglycols et polyalcools, qui sont utilisés en proportions de 0,01 à 10 % en volume.

10. Procédé selon l'une des revendications 1 à 9, **caractérisé en ce que** le chiffon de polissage utilisé sur le deuxième plateau de polissage est plus doux que le chiffon de polissage utilisé sur le premier plateau de polissage.

11. Procédé selon l'une des revendications 1 à 10, **caractérisé en ce qu'**après le polissage de surface, on réalise un nettoyage et un séchage du disque de silicium, suivi par l'application d'un revêtement épitaxial sur le disque de silicium.
